# FASCICULE DE BREVET EUROPEEN

(11) **EP 0 664 568 B1**
(45) Date de publication et mention de la délivrance du brevet: **06.05.1999**
(21) Numéro de dépôt: 95400074.1
(22) Date de dépôt: 16.01.1995
(51) Int. Cl.: H01L 33/00, H01S 3/025

(54) **Procédé de fabrication d'une plaquette monocristalline segmentée**
Verfahren zur Herstellung eines segmentierten monokristallinen Wafers
Process for the fabrication of a segmented monocrystalline wafer

(30) Priorité: 21.01.1994 FR 9400636
(43) Date de publication de la demande: 26.07.1995
(73) Titulaire: ALCATEL, 75008 Paris (FR)
(72) Inventeur: Gaumont-Goarin, Elizabeth, F-92120 Montrouge (FR); Labourie, Christine, F-94800 Villejuif (FR); Emery, Jean-Yves, F-75010 Paris (FR)
(74) Mandataire: Bourely, Paul

(56) Documents cités:
- EP-A- 0 261 943
- GB-A- 2 175 442
- US-A- 4 820 655
- US-A- 5 157 000
- PATENT ABSTRACTS OF JAPAN vol. 16, no. 492 (E-1278) 12 Octobre 1992 & JP-A-04 180 687 (NEC CORP) 26 Juin 1992
- PATENT ABSTRACTS OF JAPAN vol. 14, no. 308 (E-947) 03 Juillet 1990 & JP-A-02 100 387 (THE FURUKAWA ELECTRIC CO LTD) 12 Avril 1990
- PATENT ABSTRACTS OF JAPAN vol. 13, no. 86 (E-720) 28 Février 1989 & JP-A-63 263 726 (MATSUSHITA ELECTRIC IND CO LTD) 31 Octobre 1988

## Description

La présente invention concerne un procédé de fabrication d'une plaquette monocristalline segmentée, notamment d'une plaquette semiconductrice devant effectuer plusieurs traitements sur une lumière guidée en son sein. Deux tels traitements sont constitués par la création d'une lumière laser et par une modulation de cette lumière.

Lors de la fabrication d'un laser semi-conducteur à modulateur incorporé, il est nécessaire de coupler bout à bout deux structures semi-conductrices incluant deux couches guidantes de compositions différentes. On forme ainsi deux segments successifs appartenant à un même guide optique et assurant les deux fonctions de création et de modulation de la lumière, respectivement.

On a effectué jusqu'ici un tel couplage en formant une première structure semi-conductrice dans les deux segments, puis en l'éliminant par une attaque limitée à un segment. On forme alors la seconde structure semi-conductrice à côté de la première par des dépôts épitaxiaux.

Un tel dispositif et son procédé de fabrication sont décrits dans le document US-A-4 820 655.

Dans les procédés connus on utilise soit une attaque par voie humide à l'aide d'un réactif liquide, soit une attaque par voie sèche à l'aide d'un plasma réactif ou d'un faisceau d'ions réactifs.

Le document US-A-5 157 000 décrit un procédé comportant une attaque par voie sèche et une attaque par voie humide.

Les performances des composants fabriqués par ces procédés connus sont peu reproductibles.

La présente invention a notamment pour buts d'obtenir de manière simple des performances meilleures et plus reproductibles que précédemment.

Dans ces buts elle a pour objet un procédé de fabrication d'un dispositif électro-optique tel que défini par la revendication 1.

De préférence l'attaque de la première structure comporte d'abord une attaque initiale par voie humide pour réaliser un évidement de la première structure sous un bord du dépôt protecteur, ladite formation de la deuxième structure par dépôt sur la couche de fond s'accompagnant d'un dépôt parasite sur le dépôt protecteur, ce procédé comportant ensuite une attaque du dépôt protecteur à partir dudit évidement pour éliminer à la fois ce dépôt protecteur et ce dépôt parasite.

Typiquement chaque structure doit comporter une couche guidante présentant un indice de réfraction accru. Les couches guidantes des deux structures doivent alors être alignées pour guider une même lumière devant se propager longitudinalement dans la plaquette. Dans ce cas la couche de fond est formée par un dépôt épitaxial sur une couche de base, la composition de la couche de fond est telle que cette couche constitue une couche d'arrêt propre à arrêter ladite attaque finale par voie humide, et les couches guidantes sont formées à faible distance au-dessus de cette couche d'arrêt.

Typiquement les couches de la plaquette incluent à la fois des couches semiconductrices binaires constituées de deux corps de type III-V tels que le phosphore et l'indium, et des couches semiconductrices composites constituées en partie de ces deux mêmes corps et en partie d'autres corps compatibles avec la continuité cristalline tels que l'arsenic et le gallium. La couche de base est binaire, la couche d'arrêt est composite, et chaque structure comporte, à partir de la couche d'arrêt :
- une couche binaire inférieure,
- une couche guidante composite, les couches composites des deux structures étant mutuellement différentes,
- et une couche binaire supérieure,
le dépôt protecteur étant constitué d'un oxyde ou d'un nitrure.

Typiquement les deux structures constituant respectivement les parties semiconductrices d'un laser et d'un modulateur pour la lumière de ce laser, les couches de base, d'arrêt et binaire inférieure constituant un ensemble de confinement optique inférieur pour les couches guidantes, les couches binaires supérieure constituant des couches de confinement optique supérieures pour ces couches guidantes.

Dans le cadre de la présente invention des causes ont été trouvées pouvant expliquer les insuffisances et irrégularités de performances qui avaient été constatées pour les composants fabriqués par les procédés connus. Ces causes possibles sont les suivantes :

Les attaques par voie humide étaient réalisées avec une succession de réactifs liquides successifs, chacun de ces réactifs étant adapté à une composition de couche et attaquant sélectivement les couches ayant cette composition. L'attaque d'une couche telle qu'une couche guidante par exemple quaternaire de la première structure par un tel réactif pour éliminer cette couche dans le deuxième segment provoquait alors une sous-gravure de cette couche, c'est-à-dire que cette couche était attaquée non seulement dans le deuxième segment mais aussi sur une petite partie adjacente du premier segment.

Lors du dépôt de la deuxième structure cette sous-gravure de la couche guidante s'opposait à la réalisation d'une continuité longitudinale convenable entre les couches des deux structures. Or, dans le cas notamment des couches guidantes, une telle continuité longitudinale est nécessaire pour assurer un bon raccordement optique entre les deux structures.

Quant aux attaques par voie sèche elle provoquaient une détérioration superficielle de l'état cristallin de la couche de fond. Lors du dépôt de la deuxième structure cette détérioration superficielle s'opposait à la réalisation d'une continuité verticale convenable de cette structure à la couche de fond. Or dans le cas notamment d'un dispositif électroptique tel qu'un laser semiconducteur, une telle continuité verticale est nécessaire pour assurer un bon raccordement électrique pour des porteurs de charge se déplaçant sous l'action d'un champ électrique vertical.

Grâce à une succession convenable des attaques par voie sèche et humide la présente invention permet à la fois de réaliser la continuité verticale souhaitable sur toute la longueur de la plaquette, et de réaliser la continuité horizontale entre celles des couches des deux structures pour lesquelles cette continuité est nécessaire.

Il est décrit ci-après, à titre d'exemple et en référence aux figures schématiques du dessin annexé, la formation de deux structures semi-conductrices d'un laser semi-conducteur.

La figure 1 représente une première structure semi-conductrice.

La figure 2 représente cette structure après attaque par gravure chimique en phase liquide d'une couche binaire supérieure de phosphure d'indium dans un deuxième segment représenté à gauche.

La figure 3 représente cette structure après attaque par plasma réactif d'une couche guidante quaternaire dans le deuxième segment.

La figure 4 représente cette structure après gravure par attaque chimique en phase liquide d'une couche binaire inférieure de phosphure d'indium dans le deuxième segment.

La figure 5 représente une plaquette formée par dépôt d'une deuxième structure dans le deuxième segment, avec une couche quaternaire de composition différente de celle de la première structure.

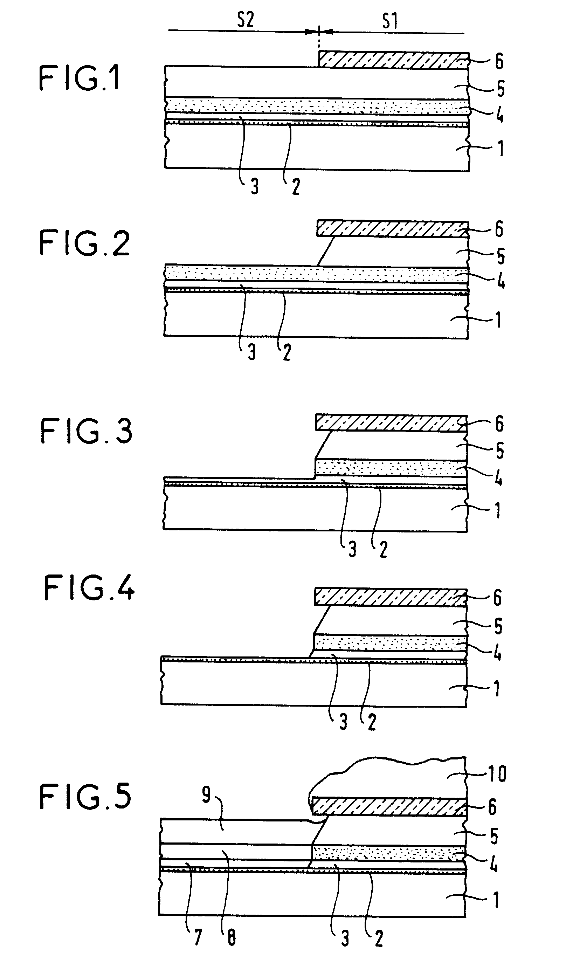

Dans la figure 1, une couche de base binaire de la première structure semi-conductrice est disposée sous une couche d'arrêt 2 en matériau par exemple quaternaire (phosphure d'indium et arséniure de gallium). Au-dessus de celle-ci, la couche inférieure binaire de phosphure d'indium 3 est surmontée par une couche guidante par exemple quaternaire 4 présentant un indice de réfraction accru pour guider une lumière à traiter par un dispositif à fabriquer, par exemple à engendrer et à moduler par un laser à modulateur intégré. La couche 4 est surmontée par une couche supérieure binaire 5. Dans le premier segment du laser à former la couche 5 est protégée par un dépôt protecteur d'oxyde ou de nitrure 6 tel que de la silice.

La structure ainsi constituée est soumise à une première opération d'attaque par un réactif chimique liquide ne réagissant pas sur l'oxyde. Ce réactif attaque la zone de la couche supérieure binaire non protégée par le dépôt d'oxyde. Cette attaque est suffisamment poussée pour évider cette couche au-dessous du rebord du dépôt d'oxyde, comme il apparaît sur la figure 2.

On élimine ensuite dans la même zone non protégée par le dépôt d'oxyde la couche quaternaire 4 par traitement par un plasma réactif pour obtenir la structure gravée représentée en figure 3.

On procède enfin à une attaque chimique légère pour éliminer la couche binaire inférieure 3. Cette attaque s'arrête sur la couche quaternaire 2.

On forme ensuite la seconde structure du laser (à gauche de la figure 5), en déposant successivement par épitaxie par jets moléculaires une couche binaire inférieure 7, une couche guidante par exemple quaternaire 8 et une couche binaire supérieure 9. La couche guidante 8 a une composition différente de celle de la couche guidante 4, de façon à assurer la fonction supplémentaire désirée. Du fait de la faible épaisseur de la couche binaire inférieure 3, on peut assurer avec une bonne précision l'alignement mutuel des couches 4 et 8.

Il se forme alors au-dessus du dépôt d'oxyde protecteur 6 un dépôt polycristallin 10.

Enfin, on élimine dans une dernière opération par attaque chimique le dépôt d'oxyde protecteur 6 et le dépôt polycristallin 10 qui le surmonte, cette élimination étant facilitée par l'évidement formée sous le bord du dépôt d'oxyde lors de la première attaque chimique.

## Revendications

1. Procédé de fabrication d'un dispositif électro-optique, le dispositif à fabriquer comportant une plaquette monocristalline semiconductrice incluant une première et une deuxième structures devant occuper respectivement un premier et un deuxième segments (S1 et S2) s'étendant et se succédant selon une longueur de cette plaquette, chaque structure étant composée de couches superposées (3, 4, 5-7, 8, 9) incluant une couche guidante située entre deux couches de confinement à composition binaire, ces deux structures étant formées sur une même couche de fond (2) faisant partie de cette plaquette, les couches guidantes (4 et 8) de ces deux structures étant alignées pour guider une même lumière devant se propager longitudinalement dans la plaquette, ce procédé comportant les étapes de :
- formation de la couche de fond par un dépôt épitaxial sur une couche de base (1),
- formation de la première structure par dépôt épitaxial sur cette couche de fond dans les deux dits segments,
- formation d'un dépôt protecteur (6) sur cette première structure dans le premier segment (S1),
- attaque de cette première structure de manière qu'elle soit éliminée dans le deuxième segment (S2) jusqu'à ladite couche de fond (2) tout en étant protégée par le dépôt protecteur dans le premier segment, et
- formation de la deuxième structure par dépôt épitaxial sur la couche de fond, cette formation débutant par le dépôt d'une couche à composition binaire (7),
ce procédé étant caractérisé par le fait que ladite attaque de la première structure comporte une attaque par voie sèche éliminant la couche guidante et suivie par une attaque finale par voie humide attaquant une couche à composition binaire jusqu'à atteindre la couche de fond, la composition de cette couche de fond étant telle que cette couche constitue une couche d'arrêt propre à arrêter cette attaque finale, les couches guidantes étant formées au dessus de cette couche d'arrêt à une distance faible, le dépôt épitaxial formant la deuxième structure assurant ainsi avec bonne précision l'alignement mutuel des deux couches guidantes.

2. Procédé selon la revendication 1 lesdites couches étant soit des couches semiconductrices binaires constituées de deux corps de type III-V soit des couches semiconductrices composites constituées en partie de ces deux corps, la couche de base (1) étant binaire, la couche d'arrêt (2) étant composite, chaque dite structure comportant, à partir de la couche d'arrêt :
- une couche binaire inférieure (3),
- une couche guidante composite, les couches composites (8, 4) des deux structures étant mutuellement différentes, et une couche binaire supérieure (5),
le dépôt protecteur (6) étant constitué d'un oxyde ou d'un nitrure.

3. Procédé selon la revendication 1, les deux dites structures constituant respectivement les parties semiconductrices d'un laser et d'un modulateur pour la lumière de ce laser, lesdites couches de base (1), d'arrêt (2) et binaire inférieure (3 et 7) constituant un ensemble de confinement optique inférieur pour lesdites couches guidantes, lesdites couches binaires supérieure (5 et 9) constituant des couches de confinement optique supérieures pour ces couches guidantes.

4. Procédé selon la revendication 1 caractérisé par le fait que l'attaque de la première structure comporte d'abord une attaque initiale par voie humide pour réaliser un évidement de la première structure sous un bord du dépôt protecteur (6), ladite formation de la deuxième structure par dépôt sur la couche de fond (2) s'accompagnant d'un dépôt parasite (10) sur le dépôt protecteur, ce procédé comportant ensuite une attaque du dépôt protecteur à partir dudit évidement pour éliminer à la fois ce dépôt protecteur et ce dépôt parasite.

## Claims

1. A method of fabricating an electro-optical device, the device to be fabricated including a semiconductive monocrystalline chip including first and second structures respectively occupying first and second segments (S1 and S2) extending one after the other along a length direction of the chip, each structure being made up of superposed layers (3, 4, 5-7, 8, 9) including a guiding layer situated between two confinement layers having binary composition, the two structures being formed on a common bottom layer (2) that forms a portion of the chip, the guiding layers (4 and 8) of the two structures being in alignment to guide the same light propagating longitudinally through the chip, said method comprising the following steps:
the bottom layer is formed by epitaxial deposition on a base layer;
the first structure is formed by epitaxial deposition on said bottom layer in both of said segments;
a protective deposit (6) is formed on said structure in the first segment (S1);
said first structure is etched so as to be eliminated down to said bottom layer (2) in the second segment (S2) while being protected by the protective deposit in the first segment; and
the second structure is formed by epitaxial deposition on the bottom layer, said formation being started by deposition of a layer having binary composition (7);
the method being characterized by the fact that said etching of the first structure includes dry etching which eliminates the guiding layer, followed by final wet etching which etches a layer having binary composition until the bottom layer is reached, the composition of the bottom layer being such that said layer constitutes a stop layer suitable for stopping said final etching, the guiding layers being formed a short distance above said stop layer, the epitaxial deposition which forms the second structure thus ensuring, with high accuracy, that the two guiding layers are in mutual alignment.

2. A method according to claim 1, said layers being either binary semiconductor layers constituted by two III-V type substances or else composite semiconductor layers constituted in part by said two substances, the base layer (1) being binary, the stop layer (2) being composite, and each of said structures comprising, from said stop layer:
a lower binary layer (3);
a composite guiding layer, the composite layers (8, 4) of the two structures being mutually different; and
an upper binary layer (5);
the protective deposit (6) being constituted by an oxide or a nitride.

3. A method according to claim 1, in which said two structures respectively constitute the semiconductor portions of a laser and of a modulator for modulating the light from the laser, said base layer (1), stop layer (2), and lower binary layers (3 and 7) constituting a lower optical confinement assembly for said guiding layers, said upper binary layers (5 and 9) constituting upper optical confinement layers for said guiding layers.

4. A method according to claim 1, characterized by the fact that the etching of the first structure includes firstly initial wet etching to undercut the first structure beneath an edge of the protective deposit (6), said fabrication of the second structure by deposition on the bottom layer (2) being accompanied by parasitic deposition (10) on the protective deposit. the method then including etching of said protective deposit from said undercut to remove both the protective deposit and the parasitic deposit.

## Patentansprüche

1. Verfahren zur Herstellung einer optoelektronischen Vorrichtung, wobei die herzustellende Vorrichtung einen monokristallinen Halbleiterwafer mit einer ersten und einer zweiten Struktur umfasst, die jeweils ein erstes und ein zweites Segment (S1 und S2) belegen sollen, die sich in einer Längsrichtung dieses Wafers erstrecken und aufeinander folgen, wobei jede Struktur aus übereinanderliegenden Schichten (3, 4, 5-7, 8, 9) aufgebaut ist, die eine zwischen zwei Einschließungsschichten mit binärer Zusammensetzung angeordnete leitende Schicht umfassen, wobei diese zwei Strukturen auf einer gleichen Bodenschicht (2) gebildet sind, die Teil des Wafers ist, wobei die leitenden Schichten (4 und 8) dieser zwei Strukturen ausgerichtet sind, um gleiches Licht zu leiten, das sich longitudinal im Wafer ausbreiten soll, wobei das Verfahren die Schritte umfasst:
- Erzeugen der Bodenschicht durch epitaxiale Abscheidung auf einer Basisschicht (1),
- Erzeugen der ersten Struktur durch epitaxiale Abscheidung auf dieser Bodenschicht in den zwei Segmenten,
- Erzeugen einer Schutzabscheidung (6) auf dieser ersten Struktur im ersten Segment (S1),
- Angriff auf diese erste Struktur, so dass sie im zweiten Segment (S2) bis zu der Bodenschicht (2) beseitigt wird, wobei sie in dem ersten Segment durch die Schutzabscheidung geschützt ist, und
- Erzeugung der zweiten Struktur durch epitaxiale Abscheidung auf der Bodenschicht, wobei diese Erzeugung mit dem Abscheiden einer Schicht mit binärer Zusammensetzung (7) beginnt, dadurch gekennzeichnet, dass der Angriff auf die erste Struktur einen Trockenangriff, der die leitende Schicht beseitigt, und danach einen abschließenden Nassangriff, der eine Schicht mit binärer Zusammensetzung angreift, bis die Bodenschicht erreicht wird, umfasst, wobei die Zusammensetzung dieser Bodenschicht derart ist, dass diese Schicht eine Stopschicht bildet, die in der Lage ist, diesen abschließenden Angriff zu stoppen, wobei die leitenden Schichten über dieser Stopschicht in einem geringen Abstand gebildet sind, so dass die epitaxiale Abscheidung, die die zweite Struktur bildet, die gegenseitige Ausrichtung der zwei leitenden Schichten mit guter Genauigkeit sicherstellt.

2. Verfahren nach Anspruch 1, bei dem die Schichten binäre Halbleiterschichten, die aus zwei Körpern vom Typ III-V bestehen, oder Verbund-Halbleiterschichten sind, die zum Teil aus diesen zwei Körpern bestehen, wobei die Basisschicht (1) binär ist, die Stopschicht (2) ein Verbund ist, und wobei jede Struktur von der Stopschicht aus umfasst:
- eine untere binäre Schicht (3),
- eine leitende Verbundschicht, wobei die Verbundschichten (8, 4) der zwei Strukturen voneinander verschieden sind, und eine obere binäre Schicht (5),
wobei der Schutzüberzug (6) aus einem Oxid oder einem Nitrid besteht.

3. Verfahren nach Anspruch 1, bei dem die zwei Strukturen jeweils die halbleitenden Bereiche eines Lasers und eines Modulators für das Licht dieses Lasers bilden, wobei die Basisschicht (1), die Stopschicht (2) und die untere binäre Schicht (3 und 7) eine untere optische Einschließungsanordnung für die leitenden Schichten und die oberen binären Schichten (5 und 9) obere optische Einschließungsschichten für diese leitenden Schichten bilden.

4. Verfahren nach Anspruch 1, dadurch gekennzeichnet, dass der Angriff auf die erste Struktur zunächst einen anfänglichen Nassangriff zum Bilden einer Ausnehmung der ersten Struktur unter einem Rand der Schutzabscheidung (6) umfasst, wobei die Erzeugung der zweiten Struktur durch Abscheidung auf der Bodenschicht (2) begleitet ist von einer parasitären Abscheidung (10) auf der Schutzabscheidung, wobei das Verfahren anschließend einen Angriff auf die Schutzabscheidung von der Ausnehmung aus zum gleichzeitigen Beseitigen der Schutzabscheidung und der parasitären Abscheidung umfasst.
